# EUROPEAN PATENT APPLICATION

(11) **EP 2 469 612 A2**
(43) Date of publication of application: **27.06.2012**
(21) Application number: 11177729.8
(22) Date of filing: 17.08.2011
(51) Int. Cl.: H01L 33/00, H01L 21/02, H01L 33/32

(54) **Method of manufacturing light emitting diode**

(30) Priority: 22.12.2010 KR 20100132393
(71) Applicant: Samsung LED Co., Ltd., Gyunggi-do (KR)
(72) Inventor: Han, Sang Heon, Gyunggi-do (KR); Rhee, Do Young, Seoul (KR); Lim, Jin Young, Gyunggi-do (KR); Kim, Ki Sung, Gyunggi-do (KR); Kim, Young Sun, Gyunggi-do (KR)
(74) Representative: Grünecker, Kinkeldey, Stockmair & Schwanhäusser

(57) **Abstract**

There is provided a method of manufacturing a light emitting diode, the method including: growing a first conductivity type nitride semiconductor layer and an active layer on a substrate in a first reaction chamber; transferring the substrate having the first conductivity type nitride semiconductor layer and the active layer grown thereon to a second reaction chamber; and growing a second conductivity type nitride semiconductor layer on the active layer in the second reaction chamber, wherein an atmosphere including a nitride source gas and a dopant source gas supplying a dopant to be included in the second conductivity type nitride semiconductor layer is created in an interior of the second reaction chamber prior to the transferring of the substrate to the second reaction chamber. This method improves a system's operational capability and productivity. In addition, the crystallinity and doping uniformity of semiconductor layers obtained by this method may be improved.

## Description

### CROSS-REFERENCE TO RELATED APPLICATIONS

This application claims the priority of Korean Patent Application No. 10-2010-0132393 filed on December 22, 2010, in the Korean Intellectual Property Office, the disclosure of which is incorporated herein by reference.

### BACKGROUND OF THE INVENTION

### Field of the Invention

The present invention relates to a method of manufacturing a light emitting diode (LED).

### Description of the Related Art

A light emitting diode (LED) is a semiconductor device that can emit light of various colors due to electron-hole recombination occurring at a p-n junction when a current is supplied thereto. These LEDs, greatly advantageous over filament-based light emitting devices, have a long lifespan, low power usage, superior initial-operation characteristics, and high vibration resistance. These factors have continually boosted the demand for LEDs. Particularly, group III nitride semiconductors that can emit light in the blue/short wavelength region have recently drawn much attention.

Nitride semiconductor crystals, constituting a light emitting device using the group III nitride semiconductor, are grown on a sapphire or SiC substrate. In order to grow the semiconductor crystals, a plurality of gas-state sources are deposited on the substrate by a chemical vapor deposition process. The light emission performance and reliability of a semiconductor light emitting device may be greatly affected by the quality of semiconductor layers (crystallinity, doping uniformity, and the like) . Here, the quality of semiconductor layers may depend on the structure, internal environment and usage conditions of a vapor deposition apparatus used for the growth of semiconductor thin films. Therefore, there is a need in this technical field for a method of improving the quality of semiconductor layers by optimizing the vapor deposition process.

### SUMMARY OF THE INVENTION

An aspect of the present invention provides a method of manufacturing a light emitting diode, in which a system's operational capability and productivity may be improved, while the crystallinity and doping uniformity of semiconductor layers obtained by this method may be improved.

According to an aspect of the present invention, there is provided a method of manufacturing a light emitting diode, the method including: growing a first conductivity type nitride semiconductor layer and an active layer on a substrate in a first reaction chamber; transferring the substrate having the first conductivity type nitride semiconductor layer and the active layer grown thereon to a second reaction chamber; and growing a second conductivity type nitride semiconductor layer on the active layer in the second reaction chamber, wherein an atmosphere including a nitride source gas and a dopant source gas supplying a dopant to be included in the second conductivity type nitride semiconductor layer is created in an interior of the second reaction chamber prior to the transferring of the substrate to the second reaction chamber.

The second conductivity type nitride semiconductor layer may be a p-type nitride semiconductor layer, and the dopant source gas may include at least one of Mg and Zn.

The nitride source gas may include NH₃.

The interior of the second reaction chamber may be coated with a compound including the dopant prior to the transferring of the substrate to the second reaction chamber.

The interior of the second reaction chamber may be maintained at a temperature higher than a growth temperature of the second conductivity type nitride semiconductor layer prior to the transferring of the substrate to the second reaction chamber.

The transferring of the substrate to the second reaction chamber may be performed in a vacuum state.

According to another aspect of the present invention, there is provided a method of manufacturing a light emitting diode, the method including: growing a first conductivity type nitride semiconductor layer on a substrate in a first reaction chamber; transferring the substrate having the first conductivity type nitride semiconductor layer grown thereon to a second reaction chamber; growing an active layer on the first conductivity type nitride semiconductor layer in the second reaction chamber; and growing a second conductivity type nitride semiconductor layer on the active layer, wherein an atmosphere including a source gas for one or more materials constituting the active layer is created in an interior of the second reaction chamber prior to the transferring of the substrate to the second reaction chamber.

The interior of the second reaction chamber may be coated with a compound including one or more elements constituting the active layer prior to the transferring of the substrate to the second reaction chamber.

The compound coated on the interior of the second reaction chamber may be identical to at least part of the one or more materials included in the active layer.

The active layer may be formed of a nitride semiconductor material including In, and the source gas may include an In source gas.

The the active layer may include an InGaN compound, and the source gas may include TMGa or TEGa as a Ga source gas, TMIn as an In source gas, and NH₃ as an N source gas.

The interior of the second reaction chamber may be coated with the InGaN compound prior to the transferring of the substrate to the second reaction chamber.

The interior of the second reaction chamber may be maintained at a temperature higher than a growth temperature of the active layer prior to the transferring of the substrate to the second reaction chamber.

The method may further include transferring the substrate having the active layer grown thereon to a third reaction chamber prior to the growing of the second conductivity type nitride semiconductor layer.

An atmosphere including a nitride source gas and a dopant source gas supplying a dopant to be included in the second conductivity type nitride semiconductor layer may be created in an interior of the third reaction chamber prior to the transferring of the substrate to the third reaction chamber.

The interior of the third reaction chamber may be coated with a compound including the dopant prior to the transferring of the substrate to the third reaction chamber.

The second conductivity type nitride semiconductor layer may be a p-type nitride semiconductor layer, and the dopant source gas may include at least one of Mg and Zn.

The nitride source gas may include NH₃.

At least one of the transferring of the substrate to the second reaction chamber and the transferring of the substrate to the third reaction chamber may be performed in a vacuum state.

### BRIEF DESCRIPTION OF THE DRAWINGS

The above and other aspects, features and other advantages of the present invention will be more clearly understood from the following detailed description taken in conjunction with the accompanying drawings, in which:
FIGS. 1 through 4 are views schematically illustrating a method of manufacturing a light emitting diode according to an exemplary embodiment of the present invention; and
FIGS. 5 through 7 are views schematically illustrating a method of manufacturing a light emitting diode according to another exemplary embodiment of the present invention.

### DETAILED DESCRIPTION OF THE PREFERRED EMBODIMENT

Exemplary embodiments of the present invention will now be described in detail with reference to the accompanying drawings,

The invention may, however, be embodied in many different forms and should not be construed as being limited to the embodiments set forth herein. Rather, these embodiments are provided so that this disclosure will be thorough and complete, and will fully convey the scope of the invention to those skilled in the art.

In the drawings, the shapes and dimensions may be exaggerated for clarity, and the same reference numerals will be used throughout to designate the same or like components.

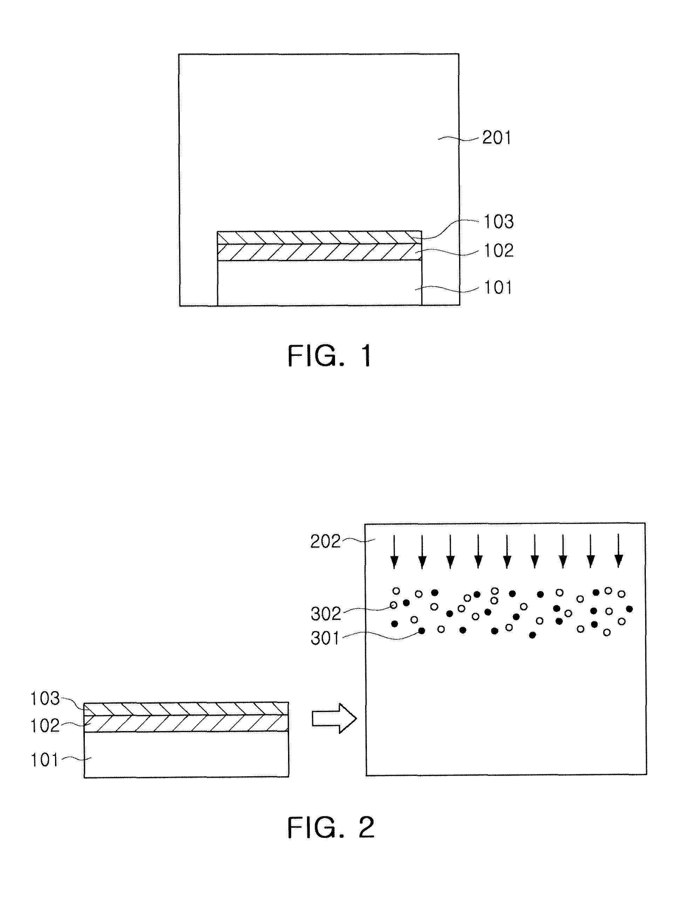

FIGS. 1 through 4 are views schematically illustrating a method of manufacturing a light emitting diode according to an exemplary embodiment of the present invention. As shown in FIG. 1, a first conductivity type nitride semiconductor layer 102 is grown on a substrate 101. This operation is conducted in a first reaction chamber 201. The growth of the first conductivity type nitride semiconductor layer 102 may be performed by Metal Organic Chemical Vapor Deposition (MOCVD) , Hydride Vapor Phase Epitaxy (HVPE), Molecular Beam Epitaxy (MBE), Atomic Layer Deposition (ALD) or the like. The MOCVD process may be the most appropriate process for creating a source gas atmosphere in a second reaction chamber 202 in advance, as will be described below. In this case, although not specifically shown, the first reaction chamber 201 may have a structure including a susceptor, in which the substrate 101 is disposed, and a gas flow path, through which a source gas is drawn.

The substrate 101 is provided for the growth of a semiconductor layer, and a substrate formed of sapphire, SiC, MgAl₂O₄, MgO, LiAlO₂, LiGa0₂, GaN, Si or the like may be used therefor. A sapphire substrate is formed of a crystal having Hexa-Rhombo R3c symmetry, and has a lattice constant of 13.001 Å in a C-axis and a lattice constant of 4.758 Å in an A-axis. Orientation planes of the sapphire substrate include a C (0001) plane, an A (1120) plane, anR (1102) plane, etc. Tn particular, the C plane is mainly used as a substrate for nitride growth as it facilitates the growth of a nitride film and is stable at a high temperature. The first conductivity type nitride semiconductor layer 102 may be formed of semiconductor materials having a composition formula AlₓIn_{y}Ga_{(1-x-y)}N (0≤x≤1, 0≤y≤1 and 0≤x+y≤1) and doped with n-type impurities such as Si or the like. However, the invention is not limited thereto. Although not shown, a buffer layer such as an undoped semiconductor layer or the like may be grown before the growth of the first conductivity type nitride semiconductor layer 102 so that degradation of the crystalline characteristics of the first conductivity type nitride semiconductor layer 102 may be minimized.

Next, an active layer 103 is grown on the first conductivity type nitride semiconductor layer 102. The active layer 103 may be disposed between the first and second conductivity type nitride semiconductor layers 102 and 104, emit light having a predetermined level of energy through electron-hole recombination, and have a multi-quantum-well (MQW) structure in which quantum well layers and quantum barrier layers are alternately stacked. The MQW structure may be a multilayer structure of AlₓIn_{y}Ga_{(1-x-y)}N (0≤x≤1, 0≤y≤1 and 0≤x+y≤1) and employ an InGaN/GaN structure, for example. In this case, the active layer 103 may be grown in the same manner as the first conductivity type nitride semiconductor layer 102 by using a process such as MOCVD or the like.

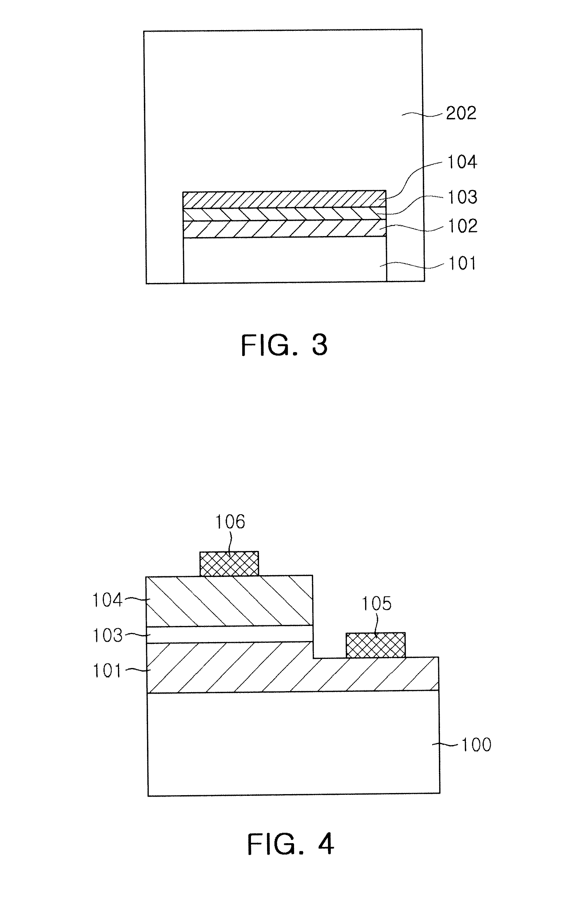

Next, as shown in FIG. 2, the substrate 101 having the first conductivity type nitride semiconductor layer 102 and the active layer 103 formed thereon may be transferred to the second reaction chamber 202. Thereafter, the remainder of a light emitting structure, i.e., the second conductivity type nitride semiconductor layer 104 is grown as shown in FIG. 3. The second conductivity type nitride semiconductor layer 104 may be formed of p-type nitride semiconductor materials having a composition formula AlₓIn_{y}Ga_{(1-x-y)}N (0≤x≤1, 0≤y≤1 and 0≤x+y≤1) and doped with p-type impurities such as Mg, Zn or the like. In the present embodiment, two or more reaction chambers are used to grow semiconductor layers forming the light emitting structure, and this may contribute to achieving a reduction in processing costs and time consumed in the occurrence of defects during the growth of semiconductor layers.

In a case in which the first and second conductivity type nitride semiconductor layers 102 and 104 and the active layer 103 constituting the light emitting structure are grown in the individual first and second reaction chambers 201 and 202 simultaneously, the individual first and second reaction chambers 201 and 202 are used for a relatively long period of time, and the amount of source gas and processing time consumed in the occurrence of defects may be relatively high as compared with the separate growth of the layers described in the present embodiment. In addition, since an initial growth process is completed by a single deposition apparatus within a relatively short period of time, the repair and maintenance of the deposition apparatus prior to a sequential growth process may be implemented flexibly. In this case, the first and second reaction chambers 201 and 202 may employ the same deposition process, but may be different deposition apparatuses. That is, both of the first and second reaction chambers 201 and 202 may be MOCVD apparatuses, or the first reaction chamber 201 may be an HVPE apparatus and the second reaction chamber 202 may be an MOCVD apparatus. In addition, even in the case that the first and second reaction chambers 201 and 202 are the MOCVD apparatuses, the structure of the MOCVD apparatuses may be different. For example, the first reaction chamber 201 may allow reactant gas to be injected in a vertical direction with respect to a susceptor, while the second reaction chamber 202 may allow reactant gas to be injected in a direction parallel to a susceptor.

In addition to the above-described advantages, since individual semiconductor layers forming the light emitting structure are different in conditions such as growth temperature, source gas atmosphere, and the like, the plurality of reaction chambers 201 and 202 are designed to maintain the growth conditions of individual semiconductor layers therein, thereby facilitating the management thereof and reducing the degradation thereof. In a case in which the light emitting structure is separately grown in the reaction chambers 201 and 202 in which growth conditions are constantly maintained, the crystalline quality and doping characteristics of individual semiconductor layers may be enhanced. For example, in a case in which the first conductivity type nitride semiconductor layer 102 includes n-type GaN, it is grown at approximately 1000°C to 1300°C. In a case in which the second conductivity type nitride semiconductor layer 104 includes p-type GaN, it is grown at a relatively low temperature of approximately 700°C to 1100°C, and the second reaction chamber 202 in which a growth temperature and a source gas atmosphere are suitable for the second conductivity type nitride semiconductor layer 104 is used to thereby improve the quality of the second conductivity type nitride semiconductor layer 104. Likewise, as will be seen in another exemplary embodiment to be described below, the active layer 103 may be separately grown in a designated chamber in which a growth temperature and a source gas atmosphere suitable therefor are maintained, and accordingly, the quality of semiconductor layers forming the active layer 103 may be improved.

In the present embodiment, in order to maximize the advantages of separate growth, a source gas atmosphere for the second conductivity type nitride semiconductor layer 104 is created in the second reaction chamber 202 in advance. That is, as shown in FIG. 2, before the substrate 101 is transferred to the second reaction chamber 202, an atmosphere including a nitride source gas 301 and a dopant source gas 302 supplying a dopant to be included in the second conductivity type nitride semiconductor layer 104 is created in the second reaction chamber 202. In this case, NH₃ or the like may be used as the nitride source gas 301 and or the like may be used as the dopant source gas 302. In a case in which the source gases are injected into the second reaction chamber 202 after the substrate 101 is transferred thereto, an Mg source gas used for doping is pre-coated on the interior of the second reaction chamber 202 without being directly injected into the second conductivity type nitride semiconductor layer 104, resulting in a doping delay in the second conductivity type nitride semiconductor layer 104.

Namely, in the early stage of the growth of the second conductivity type nitride semiconductor layer 104, the concentration of the dopant is relatively low, and accordingly, electron-hole recombination efficiency may be lowered when the semiconductor light emitting device is driven. In the present embodiment, in order to minimize such a doping delay, the dopant source gas 302 (e.g., at least one of Mg and Zn source gases) is injected into the second reaction chamber 202 prior to the transfer of the substrate 101 to thereby cause a compound including the dopant to be pre-coated on the interior of the second reaction chamber 202. Here, the interior of the second reaction chamber 202 indicates a region of the second reaction chamber 202 that can be coated with the compound, such as an inner wall of the second reaction chamber 202, a surface of the susceptor, and the like. In a case in which the nitride source gas 301, e.g., NH₃, in addition to the dopant source gas 302, e.g., Mg, is injected into the chamber, an Mg-N compound may be coated more easily.

Meanwhile, since the source gas injected prior to the transfer of the substrate 101 does not contribute to the growth of a semiconductor layer, the coating process thereof may be further accelerated by being performed at a temperature higher than the growth temperature of the second conductivity type nitride semiconductor layer 104.

Meanwhile, a method of transferring the substrate 101 is not particularly limited (for example, the substrate 101 may be artificially moved by an operator). During the transfer of the substrate 101, it is preferable to prevent the semiconductor layers from being exposed to the outside. This transfer process may be performed in a vacuum state through a load lock chamber or the like.

Then, as shown in FIG. 4, after the growth of the second conductivity type nitride semiconductor layer 104 is completed, the first and second electrodes 105 and 106 are respectively formed on an exposed surface of the first conductivity type nitride semiconductor layer 102, which is exposed by a partial removal of the light emitting structure, and the second conductivity type nitride semiconductor layer 104. This method of forming the electrodes 105 and 106 is merely an example. The electrodes 105 and 106 may be formed in various positions of the light emitting structure including the first conductivity type nitride semiconductor layer 102, the active layer 103 and the second conductivity type nitride semiconductor layer 104. For example, without the etching of the light emitting structure, an electrode may be formed on a surface of the first conductivity type nitride semiconductor layer 102 being exposed after the removal of the substrate 101.

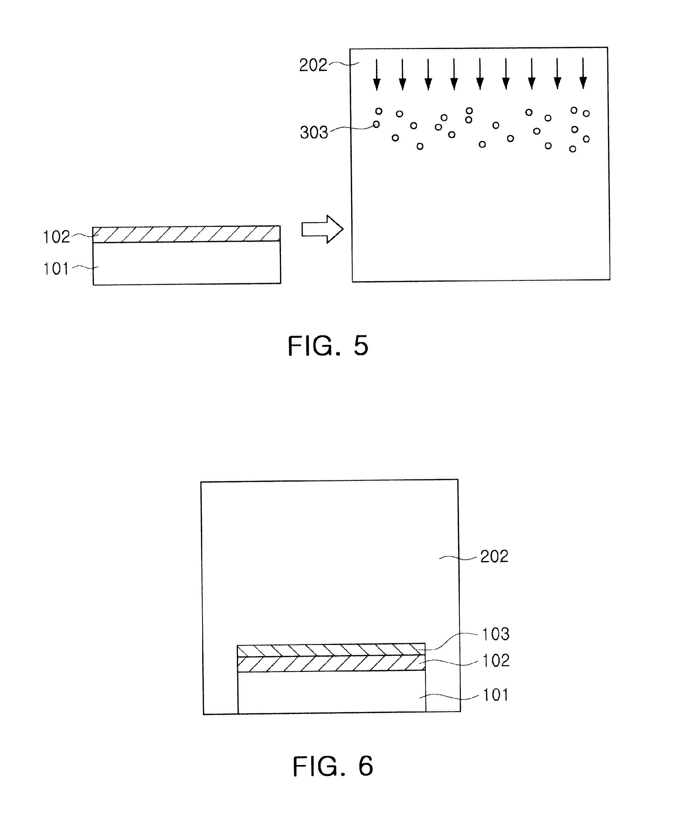

FIGS. 5 through 7 are views schematically illustrating a method of manufacturing a light emitting diode according to another exemplary embodiment of the present invention. In this embodiment, as shown in FIG. 5, the first conductivity type nitride semiconductor layer 102 is grown on the substrate 101 within the first reaction chamber 201, and the substrate 101 is then transferred to the second reaction chamber 202 (preferably, in a vacuum state). As shown in FIG. 6, prior to the transfer of the substrate 101, an atmosphere including a source gas 303 for semiconductor layers constituting the active layer 103 is created in the second reaction chamber 202. As described above, the active layer 103 has an MQW structure and is formed of a compound containing In, e.g., InGaN. The wavelength of light emitted from the active layer 103 changes according to the content of In. In a case in which the content of In is changed within the active layer 103, this may result in the light emitted therefrom being out of the range of a desired light wavelength. Accordingly, it is preferable to uniformly maintain the content of In within the active layer 103.

To enable this, an atmosphere including source gases for materials constituting the active layer 103, e.g., TMIn, TMGa (or TEGa) and NH₃, is created in the second reaction chamber 202 prior to the transfer of the substrate 101 such that the interior of the second reaction chamber 202a may be coated with a compound containing the materials constituting the active layer 103. More specifically, the compound coated in the second reaction chamber 202 may be identical to at least part of materials contained in the active layer 103 (an InGaN compound in the case of the present embodiment). In this case, since the InGaN compound is pre-coated on the interior of the second reaction chamber 202, this may allow for a uniform material composition of the active layer (the content of In). This is because when the active layer 103 is grown in the second reaction chamber 202, In is no longer coated on the interior of the second reaction chamber 202, but directly contributes to the growth of the active layer 103. Accordingly, the content of In is uniform in a thickness direction of the active layer 103.

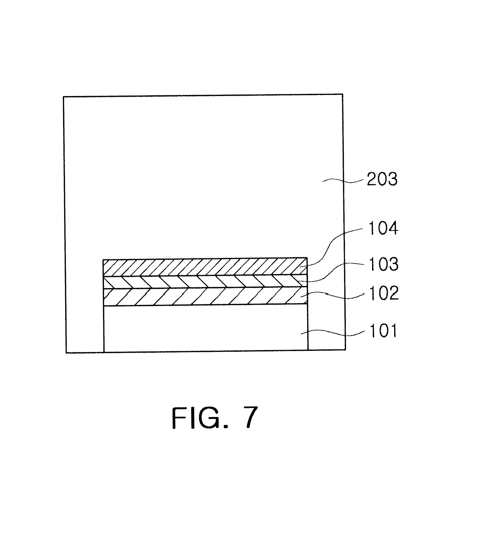

Also, the second reaction chamber 202 is a designated chamber for the growth of the active layer 103, in which a growth temperature and a gas atmosphere suitable for the growth of the active layer 103 may be maintained, thereby improving the quality of the active layer 103. Specifically, in a similar manner as described in the previous embodiment, the source gases constituting the active layer 103, for example, TMGa (or TEGa), TMIn and NH₃, which are respectively used as a Ga source gas, an In source gas and an N source gas, are injected into the second reaction chamber 202 prior to the transfer of the substrate 101, such that InGaN may be pre-coated within the second reaction chamber 202. In this case, in order to increase the coating rate, this pre-coating process may be performed at a temperature higher than the growth temperature of the active layer 103. After the growth of the active layer 103, the substrate 101 is transferred to a third reaction chamber 203 and the second conductivity type nitride semiconductor layer 104 is grown as shown in FIG. 7. In this case, as described in the previous embodiment, an atmosphere including a nitride source gas and a dopant source gas supplying a dopant to be included in the second conductivity type nitride semiconductor layer 104 is created in the third reaction chamber 203 prior to the transfer of the substrate 101, whereby a doping delay problem may be minimized. In a case in which only two chambers are provided in this embodiment, the second conductivity type nitride semiconductor layer 104 may be grown in the second reaction chamber 202.

As set forth above, in a method of manufacturing a light emitting diode according to exemplary embodiments of the invention, a system's operational capability and productivity may be improved. In addition, the crystallinity and doping uniformity of semiconductor layers obtained by this method may be improved.

While the present invention has been shown and described in connection with the exemplary embodiments, it will be apparent to those skilled in the art that modifications and variations can be made without departing from the spirit and scope of the invention as defined by the appended claims.

## Claims

1. A method of manufacturing a light emitting diode, the method comprising:
growing a first conductivity type nitride semiconductor layer and an active layer on a substrate in a first reaction chamber;
transferring the substrate having the first conductivity type nitride semiconductor layer and the active layer grown thereon to a second reaction chamber; and
growing a second conductivity type nitride semiconductor layer on the active layer in the second reaction chamber,
wherein an atmosphere including a nitride source gas and a dopant source gas supplying a dopant to be included in the second conductivity type nitride semiconductor layer is created in an interior of the second reaction chamber prior to the transferring of the substrate to the second reaction chamber.

2. The method of claim 1, wherein the second conductivity type nitride semiconductor layer is a p-type nitride semiconductor layer, and
the dopant source gas comprises at least one of Mg and Zn.

3. The method of claim 1, wherein the nitride source gas comprises.

4. The method of claim 1, wherein the interior of the second reaction chamber is coated with a compound including the dopant prior to the transferring of the substrate to the second reaction chamber.

5. The method of claim 4, wherein the interior of the second reaction chamber is maintained at a temperature higher than a growth temperature of the second conductivity type nitride semiconductor layer prior to the transferring of the substrate to the second reaction chamber.

6. The method of claim 1, wherein the transferring of the substrate to the second reaction chamber is performed in a vacuum state.

7. A method of manufacturing a light emitting diode, the method comprising:
growing a first conductivity type nitride semiconductor layer on a substrate in a first reaction chamber;
transferring the substrate having the first conductivity type nitride semiconductor layer grown thereon to a second reaction chamber;
growing an active layer on the first conductivity type nitride semiconductor layer in the second reaction chamber; and
growing a second conductivity type nitride semiconductor layer on the active layer,
wherein an atmosphere including a source gas for one or more materials constituting the active layer is created in an interior of the second reaction chamber prior to the transferring of the substrate to the second reaction chamber.

8. The method of claim 7, wherein the interior of the second reaction chamber is coated with a compound including one or more elements constituting the active layer prior to the transferring of the substrate to the second reaction chamber.

9. The method of claim 8, wherein the compound coated on the interior of the second reaction chamber is identical to at least part of the one or more materials included in the active layer.

10. The method of claim 7, wherein the active layer is formed of a nitride semiconductor material including In, and
the source gas comprises an In source gas.

11. The method of claim 7, wherein the active layer comprises an InGaN compound, and
the source gas comprises TMGa or TEGa as a Ga source gas, TMIn as an In source gas, and NH₃ as an N source gas.

12. The method of claim 11, wherein the interior of the second reaction chamber is coated with the InGaN compound prior to the transferring of the substrate to the second reaction chamber.

13. The method of claim 7, wherein the interior of the second reaction chamber is maintained at a temperature higher than a growth temperature of the active layer prior to the transferring of the substrate to the second reaction chamber.

14. The method of claim 7, further comprising transferring the substrate having the active layer grown thereon to a third reaction chamber prior to the growing of the second conductivity type nitride semiconductor layer.

15. The method of claim 14, wherein an atmosphere including a nitride source gas and a dopant source gas supplying a dopant to be included in the second conductivity type nitride semiconductor layer is created in an interior of the third reaction chamber prior to the transferring of the substrate to the third reaction chamber.

16. The method of claim 15, wherein the interior of the third reaction chamber is coated with a compound including the dopant prior to the transferring of the substrate to the third reaction chamber.

17. The method of claim 15, wherein the second conductivity type nitride semiconductor layer is a p-type nitride semiconductor layer, and
the dopant source gas comprises at least one of Mg and Zn.

18. The method of claim 15, wherein the nitride source gas comprises NH₃.

19. The method of claim 18, wherein at least one of the transferring of the substrate to the second reaction chamber and the transferring of the substrate to the third reaction chamber is performed in a vacuum state.
